# EUROPEAN PATENT APPLICATION

(11) **EP 4 783 789 A1**
(43) Date of publication of application: **29.07.2026**
(21) Application number: 24867345.1
(22) Date of filing: 11.09.2024
(51) Int. Cl.: H10H 20/812, H10H 20/816, H10H 20/00

(54) **RED-LIGHT LED EPITAXIAL STRUCTURE AND PREPARATION METHOD THEREFOR**

(30) Priority: 20.09.2023 CN 202311218230
(71) Applicant: Xiamen Silan Advanced Compound Semiconductor Co., Ltd., Xiamen, Fujian 361026 (CN)
(72) Inventor: LI, Senlin, Xiamen, Fujian 361026 (CN); BI, Jingfeng, Xiamen, Fujian 361026 (CN); XUE, Long, Xiamen, Fujian 361026 (CN); LIAO, Yinsheng, Xiamen, Fujian 361026 (CN); LAI, Yucai, Xiamen, Fujian 361026 (CN)
(74) Representative: Murgitroyd & Company
(86) International application number: PCT/CN2024/118224
(87) International publication number: WO 2025/060934

(57) **Abstract**

The present invention provides a red-light LED epitaxial structure and a preparation method therefor. The epitaxial structure includes a substrate, a first-type semiconductor layer, an active layer and a second-type semiconductor layer, which are stacked in sequence from the bottom upwards. The active layer includes a front-side quantum-well structure and a main quantum-well structure, which are stacked in sequence from the bottom upwards. The front-side quantum-well structure is a periodic structure made up of periodic units each consisting of alternately grown front-side well and barrier layers. The front-side well layers contain Al, and the front-side well layer in each preceding unit has an Al content lower than that of the front-side well layer in a succeeding unit. According to the invention, the presence of the front-side quantum-well structure enables the red-light LED to exhibit increased luminous intensity and improved temperature behavior.

## Description

### TECHNICAL FIELD

The present invention relates to the field of semiconductor technology and, in particular, to an epitaxial structure for a red light-emitting diode (LED) and a method of preparing the structure.

### BACKGROUND

A light-emitting diode (LED) is a solid-state light-emitting semiconductor device, which incorporates a semiconductor p-n junction as a light-emitting component and directly converts electricity into light. In recent years, LEDs have found extensive use because of their many advantages including low power consumption, a long service life, small size, high energy efficiency and environmental friendliness. In particular, as metal-organic chemical vapor deposition (MOCVD) epitaxy technology is established, red-light LEDs represented by those based on aluminum gallium indium phosphide (AlGaInP) have undergone rapid development and started being put into large-scale commercialization.

For an LED, its probability of radiative carrier recombination is affected by a carrier concentration in the active layer. A lower carrier concentration will lead to a lower probability of radiative recombination of electrons and holes and hence lower luminous intensity of the LED. Temperature behavior is another critical metric for assessing the performance of an LED. A higher temperature leads to increased thermal motion within an LED and escape of more carriers therefrom, adversely affecting its probability of radiative recombination.

### SUMMARY

It is an object of the present invention to provide an epitaxial structure for a red-light LED, which contains an active layer with an increased carrier concentration and enhanced quantum confinement and therefore imparts higher luminous intensity and more favorable temperature behavior to the red-light LED, as well as a method of preparing such an epitaxial structure.

The above and other objects are attained by an epitaxial structure for a red-light LED disclosed herein, which includes a substrate, a first-type semiconductor layer, an active layer and a second-type semiconductor layer, which are stacked in sequence from the bottom upwards. The active layer includes a front-side quantum-well structure and a main quantum-well structure, which are stacked in sequence from the bottom upwards. The front-side quantum-well structure is a periodic structure made up of periodic units each consisting of alternately grown front-side well and barrier layers. The front-side well layers contains aluminum (Al), and the front-side well layer in each preceding unit has an Al content lower than that of the front-side well layer in a succeeding unit.

Optionally, in the epitaxial structure, the number of periodic units in the front-side quantum-well structure may range from 1 to 10.

Optionally, in the epitaxial structure, each front-side well layer may be made of a material including (AlₓᵢGa₁₋ₓᵢ)_{y}In_{1-y}P, where 0≤xi≤0.3 and 0.3≤y≤0.7, wherein each front-side barrier layer is made of a material including (AlₘGa₁₋ₘ)ₙIn₁₋ₙP, where 0.3≤m≤0.8 and 0.3≤n≤0.7.

Optionally, in the epitaxial structure, in the front-side quantum-well structure, the front-side well layer in each preceding unit may have a thickness greater than that of the front-side well layer in a succeeding unit.

Optionally, in the epitaxial structure, the front-side quantum-well structure may have a total thickness of 3 nm to 120 nm, wherein each periodic unit of the front-side quantum-well structure has a thickness of 3 nm to 12 nm, and the front-side well and barrier layers in each periodic unit both have a thickness of 1.5 nm to 10.5 nm.

Optionally, in the epitaxial structure, in each periodic unit of the front-side quantum-well structure, the front-side well layer may have a uniform or gradually varying Al content, wherein in the case of each front-side well layer having a gradually varying Al content, it has an indium (In) content gradually increasing in a direction from the first-type semiconductor layer to the second-type semiconductor layer.

Optionally, in the epitaxial structure, in the front-side quantum-well structure, the front-side well layer that is closest to the main quantum-well structure may have an energy band lower than or equal to that of the main quantum-well structure.

Optionally, in the epitaxial structure, the active layer may further include a backside quantum-well structure on the main quantum-well structure, which is made up of periodic units each consisting of alternately grown backside well and barrier layers.

Optionally, in the epitaxial structure, the number of periodic units in the backside quantum-well structure may range from 1 to 10.

Optionally, in the epitaxial structure, each backside well layer may be made of a material including (Al_{z}Ga_{1-z})_{w}In_{1-w}P, where 0≤z≤0.30 and 0.3≤w≤0.7, wherein each backside barrier layer is made of a material including (AlⱼₖGa₁₋ⱼₖ)_{d}In_{1-d}P, where 0.3≤jk≤1 and 0.3≤d≤0.7.

Optionally, in the epitaxial structure, in the backside quantum-well structure, the backside barrier layer in each preceding unit may have an Al content lower than or equal to that of the backside barrier layer in a succeeding unit.

Optionally, in the epitaxial structure, in the backside quantum-well structure, the backside barrier layer in each preceding unit may have a thickness less than or equal to that of the backside barrier layer in a succeeding unit.

Optionally, in the epitaxial structure, the backside quantum-well structure may have a total thickness of 3 nm to 120 nm, wherein each periodic unit of the backside quantum-well structure has a thickness of 3 nm to 12 nm, and the backside well and barrier layers in each periodic unit both have a thickness of 1.5 nm to 10.5 nm.

Optionally, in the epitaxial structure, in each periodic unit of the backside quantum-well structure, the backside barrier layer may have a uniform or gradually varying Al content, wherein in the case of each backside barrier layer having a gradually varying Al content, this Al content gradually increases in the direction from the first-type semiconductor layer to the second-type semiconductor layer.

Optionally, in the epitaxial structure, the main quantum-well structure may be made up of periodic units each consisting of alternately grown main well and barrier layers, wherein the front-side barrier layers have the same material, thickness and composition as the main barrier layers, and the backside well layers have the same material, thickness and composition as the main well layers.

Optionally, in the epitaxial structure, the main quantum-well structure may have a total thickness of 15 nm to 420 nm, wherein each periodic unit of the main quantum-well structure has a thickness of 3 nm to 12 nm, and the main well and barrier layers in each periodic unit both have a thickness of 1.5 nm to 10.5 nm.

Optionally, the epitaxial structure may further include a bottom buffer layer and an etch stop layer, which are sequentially stacked in the order, the bottom buffer layer residing on the substrate, the etch stop layer situated between the bottom buffer layer and the first-type semiconductor layer.

Optionally, in the epitaxial structure, the first-type semiconductor layer may include a first-type ohmic contact layer, a first-type window layer, a first-type confinement layer and a first barrier layer, which are stacked in sequence from the bottom upwards.

Optionally, in the epitaxial structure, the second-type semiconductor layer may include a second barrier layer, a second-type confinement layer, a second-type current-spreading layer and a second-type ohmic contact layer, which are stacked in sequence from the bottom upwards.

The above and other objects are also attained by a method of preparing an epitaxial structure for a red-light LED disclosed herein, which includes the steps of:
providing a substrate;
sequentially growing a first-type semiconductor layer and an active layer over the substrate, the active layer including a front-side quantum-well structure and a main quantum-well structure, which are stacked in sequence from the bottom upwards, the front-side quantum-well structure in the form of a periodic structure made up of periodic units each consisting of alternately grown front-side well and barrier layers, the front-side well layers containing aluminum (Al), the front-side well layer in each preceding unit having an Al content lower than that of the front-side well layer in a succeeding unit; and
growing a second-type semiconductor layer over the active layer.

Optionally, in the method, the number of periodic units in the front-side quantum-well structure may range from 1 to 10.

Optionally, in the method, each front-side well layer may be made of a material including (AlₓᵢGa₁₋ₓᵢ)_{y}In_{1-y}P, where 0≤xi≤0.3 and 0.3≤y≤0.7, wherein each front-side barrier layer is made of a material including (AlₘGa₁₋ₘ)ₙIn₁₋ₙP, where 0.3≤m≤0.8 and 0.3≤n≤0.7.

Optionally, in the method, in the front-side quantum-well structure, the front-side well layer in each preceding unit may have a thickness greater than that of the front-side well layer in a succeeding unit.

Optionally, in the method, the front-side quantum-well structure may have a total thickness of 3 nm to 120 nm, wherein each periodic unit of the front-side quantum-well structure has a thickness of 3 nm to 12 nm, and the front-side well and barrier layers in each periodic unit both have a thickness of 1.5 nm to 10.5 nm.

Optionally, in the method, in each periodic unit of the front-side quantum-well structure, the front-side well layer may have a uniform or gradually varying Al content, wherein in the case of each front-side well layer having a gradually varying Al content, it has an indium (In) content gradually increasing in a direction from the first-type semiconductor layer to the second-type semiconductor layer.

Optionally, in the method, in the front-side quantum-well structure, the front-side well layer that is closest to the main quantum-well structure may have an energy band lower than or equal to that of the main quantum-well structure.

Optionally, in the method, the active layer may further include a backside quantum-well structure on the main quantum-well structure, which is made up of periodic units each consisting of alternately grown backside well and barrier layers.

Optionally, in the method, the number of periodic units in the backside quantum-well structure may range from 1 to 10.

Optionally, in the method, each backside well layer may be made of a material including (Al_{z}Ga_{1-z})_{w}In_{1-w}P, where 0≤z≤0.30 and 0.3≤w≤0.7, wherein each backside barrier layer is made of a material including (AlⱼₖGa₁₋ⱼₖ)_{d}In_{1-d}P, where 0.3≤jk≤1 and 0.3≤d≤0.7.

Optionally, in the method, in the backside quantum-well structure, the backside barrier layer in each preceding unit may have an Al content lower than or equal to that of the backside barrier layer in a succeeding unit.

Optionally, in the method, in the backside quantum-well structure, the backside barrier layer in each preceding unit may have a thickness less than or equal to that of the backside barrier layer in a succeeding unit.

Optionally, in the method, the backside quantum-well structure may have a total thickness of 3 nm to 120 nm, wherein each periodic unit of the backside quantum-well structure has a thickness of 3 nm to 12 nm, and the backside well and barrier layers in each periodic unit both have a thickness of 1.5 nm to 10.5 nm.

Optionally, in the method, in each periodic unit of the backside quantum-well structure, the backside barrier layer may have a uniform or gradually varying Al content, wherein in the case of each backside barrier layer having a gradually varying Al content, this Al content gradually increases in the direction from the first-type semiconductor layer to the second-type semiconductor layer.

Optionally, in the method, the main quantum-well structure may be made up of periodic units each consisting of alternately grown main well and barrier layers, wherein the front-side barrier layers have the same material, thickness and composition as the main barrier layers, and the backside well layers have the same material, thickness and composition as the main well layers.

Optionally, in the method, the main quantum-well structure may have a total thickness of 15 nm to 420 nm, wherein each periodic unit of the main quantum-well structure has a thickness of 3 nm to 12 nm, and the main well and barrier layers in each periodic unit both have a thickness of 1.5 nm to 10.5 nm.

Optionally, the method may further include: growing a bottom buffer layer and an etch stop layer between the substrate and the first-type semiconductor layer, wherein the bottom buffer layer resides on the substrate, and the etch stop layer is situated between the bottom buffer layer and the first-type semiconductor layer.

Optionally, in the method, the first-type semiconductor layer may include a first-type ohmic contact layer, a first-type window layer, a first-type confinement layer and a first barrier layer, which are stacked in sequence from the bottom upwards.

Optionally, in the method, the second-type semiconductor layer may include a second barrier layer, a second-type confinement layer, a second-type current-spreading layer and a second-type ohmic contact layer, which are stacked in sequence from the bottom upwards.

The present invention offers the following benefits over the prior art:
In the epitaxial structure, the active layer includes the front-side and main quantum-well structures, and in the front-side quantum-well structure, the front-side well layer in each preceding unit has an Al content lower than that of the front-side well layer in a succeeding unit. With this arrangement, a higher carrier concentration, and hence a higher probability of radiative carrier recombination, can be obtained, resulting in increased luminous intensity and reducing the escape of carriers. Moreover, an enhanced quantum confinement effect can be obtained, improving temperature behavior of the red-light LED. Meanwhile, it is ensured that a light-emission wavelength of the front-side quantum-well structure gradually varies towards a light-emission wavelength of the main quantum-well structure, without deviating from a design range.

In the front-side quantum-well structure, the front-side well layer in each preceding unit may have a greater thickness, and can therefore contain more electrons, than the front-side well layer in a succeeding unit. In this way, a higher carrier concentration, and hence a higher probability of radiative carrier recombination, can be obtained in the front-side quantum wells. Moreover, such successively decreasing thicknesses of the front-side well layers enlarge energy gaps between their bound-state energy levels and lead to their light-emission wavelengths getting successively shorter, ensuring that these light-emission wavelengths successively vary towards the light-emission wavelength of the main quantum-well structure, without deviating from the design range.

Additionally, the active layer may further include the backside quantum-well structure, which has a high potential energy barrier, and in which the backside barrier layer in each preceding unit has an Al content lower than or equal to that of the backside barrier layer in a succeeding unit, and/or the backside barrier layer in each preceding unit has a thickness less than or equal to that of the backside barrier layer in a succeeding unit. With this arrangement, a high potential energy barrier can be obtained to block the migration of electrons into the second-type semiconductor layer, resulting in a higher carrier concentration of the active layer, and hence an increased probability of radiative recombination therein. Meanwhile, carrier escape can be reduced, enabling the red-light LED to exhibit more favorable temperature behavior.

### BRIEF DESCRIPTION OF THE DRAWINGS

Fig. 1 shows a schematic representation of an epitaxial structure for a red-light LED according to an embodiment of the present invention.
Fig. 2 shows a schematic representation of an active layer according to an embodiment of the present invention.
Fig. 3 shows a schematic energy band diagram of an active layer according to an embodiment of the present invention.
Fig. 4 shows a flowchart of preparing an epitaxial structure for a red-light LED according to an embodiment of the present invention.

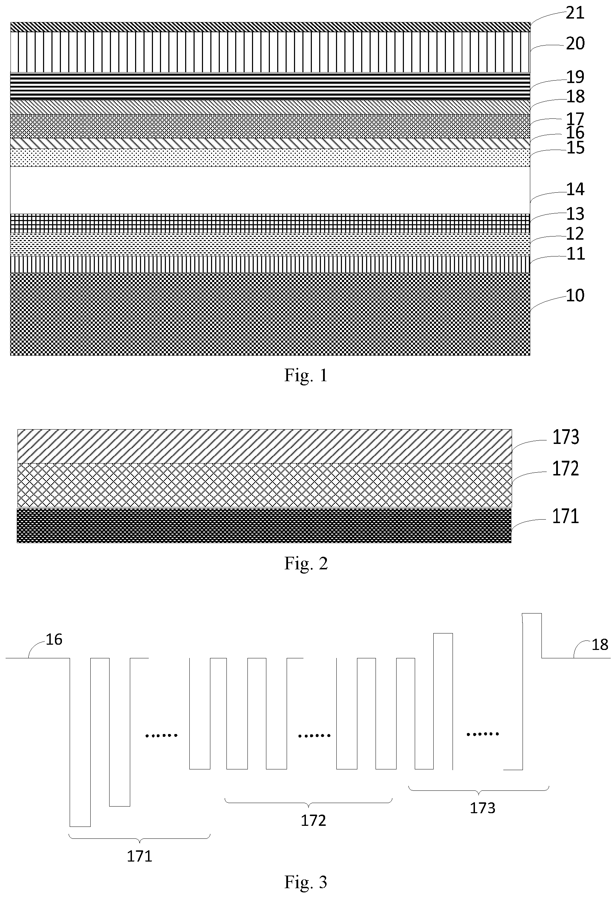

List of Reference Numerals in Figs. 1 to 4
10 substrate; 11 bottom buffer layer; 12 etch stop layer; 13 first-type ohmic contact layer; 14 first-type window layer; 15 first-type confinement layer; 16 first barrier layer; 17 active layer; 171 front-side quantum-well structure; 172 main quantum-well structure; 173 backside quantum-well structure; 18 second barrier layer; 19 second-type confinement layer; 20 second-type current-spreading layer; 21 second-type ohmic contact layer.

### DETAILED DESCRIPTION

Epitaxial structures for red-light LEDs and methods of preparing them proposed herein will be described in greater detail below with reference to the accompanying drawings, which illustrate specific embodiments of the present invention. From the following description, advantages and features of the invention will become more apparent. Note that the figures are provided in a very simplified form not necessarily drawn to exact scale for the only purpose of helping to explain the disclosed embodiments in a more convenient and clearer way.

Through extensive research, the inventors have found that the luminous intensity of an LED heavily depends on the carrier concentration of quantum wells therein and that enhancing the quantum confinement effect of an LED contributes to improving its temperature behavior and performance because it can mitigate reductions in its luminous intensity at high temperatures. Based on these findings, the present invention provides an epitaxial structure for a red-light LED, which imparts higher luminous intensity and better temperature behavior to the red-light LED.

Referring to Figs. 1 and 2, an epitaxial structure for a red-light LED according to the present invention may include a substrate 10, a first-type semiconductor layer, an active layer 17 and a second-type semiconductor layer, which are stacked in sequence from the bottom upwards.

In this embodiment, the epitaxial structure may further include a bottom buffer layer 11 and an etch stop layer 12, which are sequentially stacked in the order. The bottom buffer layer 11 resides on the substrate 10, and the etch stop layer 12 is situated between the bottom buffer layer 11 and the first-type semiconductor layer.

The first-type semiconductor layer is preferably an n-type semiconductor layer and may include a first-type ohmic contact layer 13, a first-type window layer 14, a first-type confinement layer 15 and a first barrier layer 16, which are stacked in sequence from the bottom upwards.

The active layer 17 may include a front-side quantum-well structure 171 and a main quantum-well structure 172, which are stacked in sequence from the bottom upwards. The active layer 17 may further include a backside quantum-well structure 173, the backside quantum-well structure 173 is formed on the main quantum-well structure 172.

In this embodiment, the front-side quantum-well structure 171 is a light-emitting layer. The front-side quantum-well structure 171 is a periodic structure made up of front-side quantum wells as periodic units each consisting of alternately grown front-side well and barrier layers. In this embodiment, the front-side well layer in each preceding unit has an aluminum (Al) content lower than that of the front-side well layer in a succeeding unit. Here, between every two adjacent such units, the one that is closer to the first-type semiconductor layer is referred to as a preceding unit, and the other that is closer to the second-type semiconductor layer is referred to as a succeeding unit. Having the Al content of the front-side well layer in each preceding unit lower than that of the front-side well layer in a succeeding unit allows each preceding unit (i.e., each preceding front-side quantum well) to have an energy band lower than that of a succeeding unit (i.e., a succeeding front-side quantum well) (see Fig. 3). As a result, a higher carrier concentration, and hence a higher probability of radiative carrier recombination, can be obtained, resulting in increased luminous intensity and reducing the escape of carriers. Moreover, an enhanced quantum confinement effect can be obtained, improving temperature behavior of the red-light LED. Meanwhile, the energy band of the front-side well layer that is closest to the main quantum-well structure 172 is lower than or equal to an energy band of the main quantum-well structure 172. This ensures that light-emission wavelengths of the front-side quantum wells successively vary towards a light-emission wavelength of the main quantum-well structure 172, without deviating from a design range.

In this embodiment, an enhanced quantum confinement effect and hence improved temperature behavior of the red-light LED can be obtained by a thickness design of the front-side well layers. Specifically, the front-side well layer in each preceding unit may have a greater thickness, and can therefore contain more electrons, than the front-side well layer in a succeeding unit. In this way, a higher carrier concentration, and hence a higher probability of radiative carrier recombination, can be obtained in the front-side quantum wells. Moreover, such successively decreasing thicknesses of the front-side well layers enlarge energy gaps between their bound-state energy levels and lead to their light-emission wavelengths getting successively shorter, ensuring that these light-emission wavelengths successively vary towards the light-emission wavelength of the main quantum-well structure, without deviating from the design range.

The main quantum-well structure 172 is a periodic structure consisting of alternately grown main well and barrier layers. In this embodiment, the main quantum-well structure 172 serves as a principal light-emitting layer.

In this embodiment, the backside quantum-well structure 173 may also be a light-emitting layer. The backside quantum-well structure 173 is a periodic structure consisting of backside quantum wells as periodic units each consisting of alternately grown backside well and barrier layers. In the backside quantum-well structure 173, the backside barrier layer in each preceding unit has an Al content lower than or equal to that of the backside barrier layer in a succeeding unit. Alternatively or additionally, the backside barrier layer in each preceding unit has a thickness less than or equal to that of the backside barrier layer in a succeeding unit. Here, between every two adjacent such units, the one that is closer to the first-type semiconductor layer is referred to as a preceding unit, and the other that is closer to the second-type semiconductor layer is referred to as a succeeding unit. Through having the Al content and/or thickness of the backside barrier layer in each preceding unit less than or equal to that of the backside barrier layer in a succeeding unit, migration of electrons into the second-type semiconductor layer can be blocked, resulting in a higher carrier concentration of the active layer 17 and hence a higher probability of radiative carrier recombination therein. At the same time, carrier overflow can be reduced, improving temperature behavior of the red-light LED.

The second-type semiconductor layer may include a second barrier layer 18, a second-type confinement layer 19, a second-type current-spreading layer 20 and a second-type ohmic contact layer 21, which are stacked in sequence from the bottom upwards. In this embodiment, the first-type semiconductor layer is opposite in conductivity to the second-type semiconductor layer. For example, if the first-type semiconductor layer is an n-type semiconductor layer, then the second-type semiconductor layer is a p-type semiconductor layer.

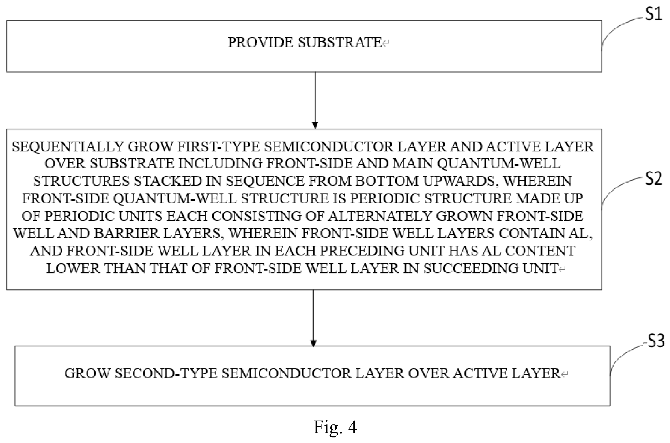

Referring to Fig. 4, the epitaxial structure described above may be fabricated according to a method including the steps of:
S1) providing a substrate 10;
S2) sequentially growing a first-type semiconductor layer and an active layer 17 over the substrate 10, the active layer 17 including a front-side quantum-well structure 171 and a main quantum-well structure 172, which are stacked in sequence from the bottom upwards, the front-side quantum-well structure 171 in the form of a periodic structure made up of periodic units each consisting of alternately grown front-side well and barrier layers, the front-side well layers containing aluminum (Al), the front-side well layer in each preceding unit having an Al content lower than that of the front-side well layer in a succeeding unit; and
S3) growing a second-type semiconductor layer over the active layer 17.

In this embodiment, the fabrication may be accomplished by, without limitation, any of a metal-organic chemical vapor deposition (MOCVD) process, a molecular beam epitaxy (MBE) process, a hydride vapor phase epitaxy (HVPE) process, a plasma-enhanced chemical vapor deposition (PECVD) process, a sputtering process and an ultra-high vacuum chemical vapor deposition (UHVCVD) process, with an MOCVD process being preferred. A specific embodiment is set forth below in the context of an MOCVD process, as an example.

In step S1, a substrate 10 is provided. In a preferred non-limiting example, the substrate 10 is a gallium arsenide (GaAs) substrate. In alternative examples, the substrate 10 may be a silicon (Si) substrate.

In the present embodiment, the epitaxial structure may further include a bottom buffer layer 11 and an etch stop layer 12, which are sequentially stacked in the order. The bottom buffer layer 11 may reside on the substrate 10, and the first-type semiconductor layer may reside on the etch stop layer 12. Accordingly, prior to step S2, the method may further include: sequentially growing the bottom buffer layer 11 and the etch stop layer 12 over the substrate 10.

The bottom buffer layer 11 can minimize the influence of surface defects of the substrate 10 on the epitaxial structure. It can reduce defects and dislocations in the epitaxial structure and provide a flat interface for subsequent growth thereon. In a preferred non-limiting example, the bottom buffer layer 11 is a GaAs layer. The bottom buffer layer 11 may be doped with a first-type (e.g., n-type) dopant. In a non-limiting example, it is doped with at least one of silicon (Si) and tellurium (Te). More preferably, the first-type dopant is Si. In this embodiment, the bottom buffer layer 11 preferably has a thickness in the range of 100 nm to 400 nm, such as 200 nm.

After the bottom buffer layer 11 is grown, the etch stop layer 12 may be grown on the bottom buffer layer 11. In a preferred non-limiting example, the etch stop layer 12 is a gallium indium phosphide (GaInP) layer. The etch stop layer 12 may be doped with a first-type (e.g., n-type) dopant. In a non-limiting example, it is doped with at least one of Si and Te. More preferably, the first-type dopant is Si. In this embodiment, the etch stop layer 12 preferably has a thickness in the range of 150 nm to 300 nm, such as 200 nm.

In step S2, a first-type semiconductor layer is grown over the substrate 10. In the case of the epitaxial structure further including a bottom buffer layer 11 and an etch stop layer 12, which are sequentially stacked in the order, the first-type semiconductor layer may be grown on the etch stop layer 12. In this embodiment, the first-type semiconductor layer is preferred to be an n-type semiconductor layer and may include, a first-type ohmic contact layer 13, a first-type window layer 14, a first-type confinement layer 15 and a first barrier layer 16, which are stacked in sequence from the bottom upwards. Accordingly, after the etch stop layer 12 is grown, the first-type ohmic contact layer 13, the first-type window layer 14, the first-type confinement layer 15 and the first barrier layer 16 may be sequentially grown over the etch stop layer 12.

The first-type ohmic contact layer 13 may be grown on the etch stop layer 12. In this embodiment, the first-type ohmic contact layer 13 is preferred to be an n-type ohmic contact layer. In a non-limiting example, the first-type ohmic contact layer 13 may be an aluminum gallium indium phosphide (AlGaInP) or GaAs layer. More preferably, the first-type ohmic contact layer 13 is a GaAs layer. The first-type ohmic contact layer 13 may be doped with a first-type (e.g., n-type) dopant. In a non-limiting example, it may be doped with one of Si and Te. More preferably, the first-type dopant is Si. In this embodiment, the first-type ohmic contact layer 13 preferably has a thickness in the range of 40 nm to 150 nm, such as 90 nm.

After the first-type ohmic contact layer 13 is grown, the first-type window layer 14 may be grown on the first-type ohmic contact layer 13. The first-type window layer 14 serves mainly for first-type current spreading, light exit and surface roughening. Preferably, the first-type window layer 14 is an n-type window layer. In a preferred non-limiting example, the first-type window layer 14 is an AlGaInP layer. The first-type window layer 14 may be doped with a first-type (e.g., n-type) dopant. In a non-limiting example, it may be doped with at least one of Si and Te. More preferably, the first-type dopant is Si. In this embodiment, the first-type window layer 14 preferably has a thickness in the range of 1 µm to 5 µm, such as 3 µm.

After the first-type window layer 14 is grown, the first-type confinement layer 15 may be grown on the first-type window layer 14. Preferably, the first-type confinement layer 15 is an n-type confinement layer. In a preferred non-limiting example, the first-type confinement layer 15 is an aluminum indium phosphide (AlInP) layer. The first-type confinement layer 15 may be doped with a first-type (e.g., n-type) dopant. In a non-limiting example, it may be doped with at least one of Si and Te. More preferably, the first-type dopant is Si. In this embodiment, the first-type confinement layer 15 preferably has a thickness in the range of 100 nm to 500 nm, such as 300 nm.

After the first-type confinement layer 15 is grown, the first barrier layer 16 may be grown on the first-type confinement layer 15. In a preferred non-limiting example, the first barrier layer 16 is an AlGaInP layer. The first barrier layer 16 is preferably not doped. That is, the first barrier layer 16 is preferred to be an undoped structural layer, which can prevent the first-type dopant from entering the active layer 17. In this embodiment, the first barrier layer 16 preferably has a thickness in the range of 5 nm to 30 nm, such as 20 nm.

After the first barrier layer 16 is grown, the active layer 17 may be grown on the first barrier layer 16. The active layer 17 includes a front-side quantum-well structure 171 and a main quantum-well structure 172. Optionally, it may further include a backside quantum-well structure 173. Accordingly, after the first barrier layer 16 is grown, the front-side quantum-well structure 171 may be grown on the first barrier layer 16.

The front-side quantum-well structure 171 is a periodic structure made up of periodic units each consisting of alternately grown front-side well and barrier layers. The number of periodic units is preferably in the range of from 1 to 10, more preferably 6. However, the number of periodic units may vary and be determined as required by practical applications. All the periodic units in the front-side quantum-well structure 171 preferably have a total thickness of 3 nm to 120 nm, and each periodic unit in the front-side quantum-well structure 171 preferably has a thickness of 3 nm to 12 nm. In this embodiment, each of the periodic unit consisting of alternately grown front-side well and barrier layers form a front-side quantum well.

Preferably, each front-side well layer is made of (AlₓᵢGa₁₋ₓᵢ)_{y}In_{1-y}P, where 0≤xi≤0.3, 0.3≤y≤0.7, and i represents an ordinal number of the periodic unit. Accordingly, i is preferably in the range of from 1 to 10, more preferably 6. In this embodiment, the front-side well layer in each preceding unit has an Al content lower than that of the front-side well layer in a succeeding unit. This allows the front-side well layer in each preceding unit to have an energy band lower than that of a succeeding unit. As a result, a higher carrier concentration, and hence a higher probability of radiative carrier recombination, can be obtained. Moreover, carrier escape can be reduced, and the quantum confinement effect can be enhanced, improving temperature behavior of the red-light LED. Meanwhile, the energy band of the front-side well layer that is closest to the main quantum-well structure 172 is lower than or equal to an energy band of the main quantum-well structure 172. This ensures that light-emission wavelengths of the front-side quantum wells successively vary towards a light-emission wavelength of the main quantum-well structure 172, without deviating from a design range. Here, between every two adjacent periodic units, the one that is closer to the first-type semiconductor layer is referred to as a preceding unit, and the other that is closer to the second-type semiconductor layer is referred to as a succeeding unit. Accordingly, a periodic unit with a smaller value of i is closer to the first semiconductor layer. On the contrary, a periodic unit with a greater value of i is closer to the second semiconductor layer. In this embodiment, the Al content of the front-side well layer in each periodic unit may be a constant amount higher than that of the front-side well layer in a preceding unit, or not. For example, there may be 6 periodic units in the front-side quantum-well structure 171, in which the front-side well layer in the first unit may have an Al content of 0.05, and Al contents of the front-side well layers in the succeeding units may successively decrease by 0.05, leading to the front-side well layer in the sixth unit having an Al content of 0.30. As another example, there may be 3 periodic units in the front-side quantum-well structure 171, in which the front-side well layer in the first unit may have an Al content of 0.05, and the front-side well layer in the second unit may have an Al content 0.03 higher than that of the front-side well layer in the first unit (i.e., the Al content of the front-side well layer in the second unit is 0.08). Moreover, the front-side well layer in the third unit may have an Al content 0.05 higher than that of the front-side well layer in the second unit (i.e., the Al content of the front-side well layer in the third unit is 0.13). Further, in each periodic unit of the front-side quantum-well structure 171, the front-side well layer may have a uniform or gradually varying Al content. In the latter case, the Al content of the front-side well layer preferably gradually increases in the direction from the first-type semiconductor layer to the second-type semiconductor layer. Such a gradually varying Al content of the front-side well layer in each periodic unit allows for more smooth transport of electrons and holes through the front-side well layers with reduced carrier recombination and loss, resulting in higher recombination efficiency of electrons and holes and higher luminous efficiency. Moreover, such gradually varying Al contents allow the red-light LED to emit light over a wider range of wavelength (i.e., over a wider spectrum), making it suitably usable in a wider variety of applications. When the front-side well layer in each periodic unit has a uniform Al content, the growth of the material layers can be accomplished in a simpler manner with less complexity and fewer errors. Moreover, such uniform Al contents enable the front-side well layers to be produced in a more robust and more repeatable manner, enhancing the performance consistency and reliability of the red-light LED. Finally, with such uniform Al contents, the red-light LED is allowed to have a simpler structure with thinner material layers and reduced complexity, and thus can be produced at lower cost.

In this embodiment, the front-side well layer in each periodic unit is preferred to have a thickness of 1.5 nm to 10.5 nm, and the front-side well layer in each preceding unit preferably has a greater thickness, and can therefore contain more electrons, than the front-side well layer in a succeeding unit. With this arrangement, a higher carrier concentration of the entire active layer 17, and hence a higher probability of radiative carrier recombination therein, can be obtained, resulting in increased luminous intensity and more favorable temperature behavior. Moreover, such successively decreasing thicknesses of the front-side well layers enlarge energy gaps between their bound-state energy levels and lead to their light-emission wavelengths getting successively shorter, ensuring that these light-emission wavelengths successively vary towards the light-emission wavelength of the main quantum-well structure, without deviating from the design range. For example, there may be two periodic units in the front-side quantum-well structure 171, in which the front-side well layer in the first unit may have a thickness of 10 nm, and the front-side well layer in the second unit may have a thickness of 8 nm.

In this embodiment, since the front-side quantum-well structure 171 is also a light-emitting layer, its light-emission wavelength would have an impact on the width of a forbidden band of, and hence the probability of radiative recombination in, the active layer 17. In this embodiment, light-emission wavelength control for the front-side quantum-well structure 171 can be achieved through either of two approaches. The first approach is to directly configure the Al contents of the front-side well layers (so that the Al content of the front-side well layer in each preceding unit is lower than that of the front-side well layer in a succeeding unit). The other approach is to configure the thicknesses of the front-side well layers (so that the thickness of the front-side well layer in each preceding unit is greater than that of the front-side well layer in a succeeding unit). Although the two approaches can be used in combination, it is preferred that only one of them is used to accomplish the light-emission wavelength control for the front-side quantum-well structure 171. According to this embodiment, altering the Al contents and/or thicknesses of the front-side well layers will lead to changes in their depths and widths, thereby exerting an impact on the probability of radiative recombination in the front-side quantum-well structure 171 and hence on the quantum confinement effect.

In this embodiment, each front-side barrier layer is preferably made of (AlₘGa₁₋ₘ)ₙIn₁₋ₙP, where 0.3≤m≤0.8 and 0.3≤n≤0.7. For example, each front-side barrier layer may be made of (A1_{0.65}Ga_{0.35})_{0.5}In_{0.5}P. The front-side barrier layer in each periodic unit is preferred to have a thickness of 1.5 nm to 10.5 nm.

After the front-side quantum-well structure 171 is grown, the main quantum-well structure 172 may be grown on the front-side quantum-well structure 171. The main quantum-well structure 172 is a periodic structure made up of periodic units each consisting of alternately grown main well and barrier layers. The number of periodic units is preferably in the range of from 5 to 35, more preferably 25. All the periodic units in the main quantum-well structure 172 preferably have a total thickness of 15 nm to 420 nm, and each periodic unit in the main quantum-well structure 172 preferably has a thickness of 3 nm to 12 nm. In this embodiment, each of the periodic unit consisting of alternately grown main well and barrier layers form a main quantum well.

The main quantum-well structure 172 serves as a main light-emitting layer and is preferably made of (AlₜGa₁₋ₜ)_{g}In_{1-g}P, where 0≤t≤0.3 and 0.3≤g≤0.7. Preferably, the main well layer in each periodic unit has a thickness of 1.5 nm to 10.5 nm. In this embodiment, the thickness of the main well layer in each periodic unit of the main quantum-well structure is preferably equal to the thickness of the front-side well layer in the last periodic unit of the front-side quantum-well structure.

Preferably, each main barrier layer is made of (AlᵤGa₁₋ᵤ)ᵥIn₁₋ᵥP, where 0.3≤u≤0.8 and 0.3≤v≤0.7. Preferably, the main barrier layer in each periodic unit has a thickness of 1.5 nm to 10.5 nm. In this embodiment, the main barrier layers preferably have the same material, thickness and composition as the front-side barrier layers. This enables better lattice matching and helps reduce issues associated with a lattice mismatch and the resulting stress, improving crystal quality of the active layer 17 and facilitating its growth. Moreover, it allows for more smooth transport of electrons and holes between the front-side quantum-well structure 171 and the main quantum-well structure 172 with reduced carrier recombination and loss, enabling more efficient carrier diffusion and transport. Further, it enables the material layers in the red-light LED to be grown in a simpler manner with less complexity and fewer errors, making the fabrication more robust and more repeatable and cost less.

After the main quantum-well structure 172 is grown, the backside quantum-well structure 173 may be grown on the main quantum-well structure 172. The backside quantum-well structure 173 is a periodic structure made up of periodic units each consisting of alternately grown backside well and barrier layers. The number of periodic units is preferably in the range of from 1 to 10, more preferably 6. However, the number of periodic units may vary and be determined as required by practical applications. All the periodic units in the front-side quantum-well structure 173 preferably have a total thickness of 3 nm to 120 nm, and each periodic unit in the backside quantum-well structure 173 preferably has a thickness of 3 nm to 12 nm. In this embodiment, each of the periodic unit consisting of alternately grown backside well and barrier layers form a backside quantum well.

Preferably, each backside well layer is made of (Al_{z}Ga_{1-z})_{w}In_{1-w}P, where 0≤z≤0.3 and 0.3≤w≤0.7. For example, z=0.3 and w=0.5. Preferably, the backside well layer in each periodic unit has a thickness of 1.5 nm to 10.5 nm. In this embodiment, the backside well layers preferably have the same material, thickness and composition as the main well layers. This enables better lattice matching and helps reduce issues associated with a lattice mismatch and the resulting stress, improving crystal quality of the materials and facilitating their growth and transport of carriers therein. Moreover, it allows for more smooth transport of electrons and holes between the backside quantum-well structure 173 and the main quantum-well structure 172 with reduced carrier recombination and loss, enabling more efficient carrier diffusion and transport. Further, it enables the material layers in the red-light LED to be grown in a simpler manner with less complexity and fewer errors, making the fabrication more robust and more repeatable and cost less.

Preferably, each backside barrier layer is made of (AlⱼₖGa₁₋ⱼₖ)_{d}In_{1-d}P, where 0.3≤jk≤1, 0.3≤d≤0.7, and k represents an ordinal number of the periodic unit. Accordingly, k is preferably in the range of from 1 to 10, more preferably 6. In this embodiment, the backside barrier layer in each preceding unit preferably has an Al content lower than or equal to that of the backside well layer in a succeeding unit. Here, between every two adjacent periodic units, the one that is closer to the first-type semiconductor layer is referred to as a preceding unit, and the other that is closer to the second-type semiconductor layer is referred to as a succeeding unit. Accordingly, a periodic unit with a smaller value of k is closer to the first semiconductor layer. On the contrary, a periodic unit with a greater value of k is closer to the second semiconductor layer. For example, there may be 6 periodic units in the backside quantum-well structure 171, in which the backside well layer in the first unit may have an Al content of 0.70, and Al contents of the backside well layers in the succeeding units may successively increase by 0.05, leading to the backside well layer in the sixth unit having an Al content of 0.95. In this embodiment, the Al contents of the backside barrier layers determine their potential energy barriers. The successively increasing Al contents of the backside barrier layers lead to their successively increasing potential energy barriers. Each potential energy barrier determines an energy level limit for electrons or holes within the active layer 17 so that only electrons or holes whose energy levels are below the specific potential energy barrier are confined by the backside barrier layer within the active layer 17. Thus, discrete energy level limits, which form a two-dimensional energy-level structure, are defined for electrons or holes in the active layer 17. This can increase the probability of radiative carrier recombination within the active layer 17. Each potential energy barrier confines the movement of electrons or holes so that they can only move within the potential energy barrier without diffusing to a region beyond the barrier. In this way, the movement of electrons or holes can be limited to one, two or three dimensions within a region defined by the potential energy barriers, reducing carrier overflow. Due to the presence of the potential energy barriers, localized resonance of electrons or holes can occur within the active layer 17. That is, electrons or holes within a certain energy range may oscillate forth and back in the active layer 17, like standing waves. Such resonance in the active layer 17 can be described by certain energy and wave functions.

In this embodiment, in each periodic unit of the backside quantum-well structure 173, the backside barrier layer may have a uniform or gradually varying Al content. In the latter case, the Al content of the backside barrier layer preferably gradually increases in the direction from first-type semiconductor layer to the second-type semiconductor layer. Such a gradually varying Al content of the backside barrier layer in each periodic unit can reduce issues associated with a lattice mismatch and the resulting stress, improving crystal quality of the active layer 17 and facilitating its growth. Moreover, such gradually varying Al contents can facilitate the transport of carriers (electrons and holes) through the backside barrier layers and reduce carrier recombination and loss during the transport, resulting in higher recombination efficiency of electrons and holes and higher luminous efficiency. When the backside barrier layer in each periodic unit has a uniform Al content, it can exhibit improved structural stability and higher resistance to high temperatures, pressure and corrosion, enhancing the stability and reliability of red-light LED. Moreover, such uniform Al contents enable the material layers in the red-light LED to be grown in a simpler manner with less complexity and fewer errors and allow the red-light LED to be fabricated at lower cost. Further, they are favorable to composition consistency of the backside barrier layers and performance consistency of the red-light LED, reducing variations between lots.

In this embodiment, the backside barrier layer in each periodic unit preferably has a thickness in the range of 1.5 nm to 10.5 nm, and the thickness of the backside barrier layer in each preceding unit is preferably lower than or equal to that of the backside barrier layer in a succeeding unit. With this design, a higher potential energy barrier can be obtained, resulting in a higher probability of radiative carrier recombination in the active layer 17 with reduced carrier overflow and hence improved temperature behavior of the red-light LED. For example, there may be two periodic units in the backside quantum-well structure 173, in which the backside well layer in the first unit may have a thickness of 8 nm, and the backside well layer in the second unit may have a thickness of 10 nm.

According to this embodiment, a higher potential energy barrier can be obtained to confine more carriers inside the active layer 17 through either of two approaches. The first approach is to configure the Al contents of the backside barrier layers (so that the Al content of the backside barrier layer in each preceding unit is lower than or equal to that of the backside barrier layer in a succeeding unit). The other approach is to configure the thicknesses of the backside barrier layers (so that the thickness of the backside barrier layer in each preceding unit is less than or equal to that of the backside barrier layer in a succeeding unit). Although the two approaches can be used in combination, it is preferred that only one of them is used to obtain a higher potential energy barrier.

In step S3, a second-type semiconductor layer is grown over the active layer 17. The second-type semiconductor layer may include a second barrier layer 18, a second-type confinement layer 19, a second-type current-spreading layer 20 and a second-type ohmic contact layer 21, which are stacked in sequence from the bottom upwards. Accordingly, after the active layer 17 is grown, the second barrier layer 18 may be grown on the active layer 17.

In a preferred non-limiting example, the second barrier layer 18 is an AlGaInP layer. The second barrier layer 18 is preferably not doped. That is, the second barrier layer 18 is preferred to be an undoped structural layer, which can prevent a second-type dopant from entering the active layer 17. Preferably, the second barrier layer 18 has a thickness in the range of 100 nm to 300 nm, such as 200 nm.

After the second barrier layer 18 is grown, the second-type confinement layer 19 may be grown on the second barrier layer 18. Preferably, the second-type confinement layer 19 is a p-type confinement layer and grown to provide holes. In this embodiment, the two confinement layers, i.e., the first-type confinement layer 15 and the second-type confinement layer 19, are formed to provide two functions. One function is to confine a small number of carriers within the active layer 17, i.e., to prevent overflow of them from the active layer 17, improving carrier recombination and luminous efficiency. The other function is to provide important windows allowing photons from the active layer 17 to readily pass therethrough, improving the red-light LED's luminous efficiency.

In a preferred non-limiting example, the second-type confinement layer 19 is an AlInP layer. In a non-limiting example, the second-type confinement layer 19 is doped with a second-type (e.g., p-type) dopant, such as at least one of magnesium (Mg) and zinc (Zn). Preferably, the second-type dopant is Mg. Preferably, the second-type confinement layer 19 has a thickness of 150 nm to 500 nm, such as 300 nm.

After the second-type confinement layer 19 is grown, the second-type current-spreading layer 20 may be grown on the second-type confinement layer 19. Preferably, the second-type current-spreading layer 20 is a p-type current-spreading layer and serves for current spreading, preventing a non-uniform current distribution within the red-light LED. In a preferred non-limiting example, the second-type current-spreading layer 20 is a GaP layer. In a preferred non-limiting example, the second-type current-spreading layer 20 is doped with Mg. Preferably, the second-type current-spreading layer 20 has a thickness of 300 nm to 3000 nm, such as 1500 nm.

After the second-type current-spreading layer 20 is grown, the second-type ohmic contact layer 21 may be grown on the second-type current-spreading layer 20. The second-type ohmic contact layer 21 is adapted to come into ohmic contact with a metal electrode. In a preferred non-limiting example, the second-type ohmic contact layer 21 is a GaP layer. The second-type ohmic contact layer 21 may be doped with carbon (C). Preferably, the second-type ohmic contact layer 21 has a thickness of 100 nm to 250 nm, such as 200 nm.

In summary, an active layer according to the present invention is constructed of a front-side quantum-well structure, a main quantum-well structure and a backside quantum-well structure. This can effectively increase a carrier concentration of the active layer, resulting in an enhanced quantum confinement effect.

According to the present invention, the front-side quantum-well structure can store electrons therein, resulting in an increased carrier concentration, and hence an increased probability of radiative carrier recombination and higher luminous intensity. Meanwhile, carrier escape can be reduced, resulting in an enhanced quantum confinement effect and more favorable temperature behavior of a red-light LED incorporating the active layer.

According to the present invention, the backside quantum-well structure provides a high potential energy barrier, which can block the migration of electrons into the second-type semiconductor layer, resulting in a higher carrier concentration of the active layer, and hence an increased probability of radiative recombination therein and higher luminous intensity. Meanwhile, carrier escape can be reduced, enabling a red-light LED incorporating the active layer to exhibit more favorable temperature behavior.

Further, it should be recognized that while the invention has been described above with reference to preferred embodiments thereof, it is not limited to these embodiments. In light of the above teachings, any person familiar with the art may make many possible modifications and variations to the disclosed embodiments or adapt them into equivalent embodiments, without departing from the scope of the invention. Accordingly, it is intended that any and all simple variations, equivalent alternatives and modifications made to the foregoing embodiments based on the substantive disclosure of the invention without departing from the scope thereof fall within the scope.

It is to be further understood that the present invention is not limited to the particular methodology, compounds, materials, fabrication techniques, uses and applications described herein, as these may vary. It is also to be understood that the terminology used herein is for the purpose of describing particular embodiments only, and is not intended to limit the scope of the present invention. It must be noted that as used herein and in the appended claims, the singular forms "a" and "an" include the plural reference unless the context clearly dictates otherwise. Thus, for example, a reference to "a step" or "a means" is a reference to one or more steps or means and may include sub-steps. All conjunctions used are to be understood in the most inclusive sense possible. Thus, the term "or" should be understood as having the definition of a logical "or" rather than that of a logical "exclusive or" unless the context clearly necessitates otherwise. Structures described herein are to be understood also to refer to functional equivalents of such structures. Language that may be construed to express approximation should be so understood unless the context clearly dictates otherwise.

## Claims

1. An epitaxial structure for a red-light LED, comprising a substrate, a first-type semiconductor layer, an active layer and a second-type semiconductor layer, which are stacked in sequence from the bottom upwards, the active layer comprising a front-side quantum-well structure and a main quantum-well structure, which are stacked in sequence from the bottom upwards, the front-side quantum-well structure in the form of a periodic structure made up of periodic units each consisting of alternately grown front-side well layers and front-side barrier layers, the front-side well layers containing aluminum (Al), an Al content of the front-side well layer in each preceding unit lower than an Al content of the front-side well layer in a succeeding unit.

2. The epitaxial structure for the red-light LED according to claim 1, wherein the number of periodic units in the front-side quantum-well structure ranges from 1 to 10.

3. The epitaxial structure for the red-light LED according to claim 1, wherein each front-side well layer is made of a material comprising (AlₓᵢGa₁₋ₓᵢ)_{y}In_{1-y}P, where 0≤xi≤ 0.3 and 0.3 ≤ y ≤ 0.7, wherein each front-side barrier layer is made of a material comprising (AlₘGa₁₋ₘ)ₙIn₁₋ₙP, where 0.3≤m≤0.8 and 0.3≤n≤0.7.

4. The epitaxial structure for the red-light LED according to claim 1, wherein in the front-side quantum-well structure, a thickness of the front-side well layer in each preceding unit is greater than a thickness of the front-side well layer in a succeeding unit.

5. The epitaxial structure for the red-light LED according to claim 1, wherein the front-side quantum-well structure has a total thickness of 3 nm to 120 nm, wherein each periodic unit of the front-side quantum-well structure has a thickness of 3 nm to 12 nm, and the front-side well layers and the front-side barrier layers in each periodic unit both have a thickness of 1.5 nm to 10.5 nm.

6. The epitaxial structure for the red-light LED according to claim 1, wherein in each periodic unit of the front-side quantum-well structure, the front-side well layer has a uniform or gradually varying Al content, wherein in the case of each front-side well layer having a gradually varying Al content, it has an indium (In) content gradually increasing in a direction from the first-type semiconductor layer to the second-type semiconductor layer.

7. The epitaxial structure for the red-light LED according to claim 1, wherein in the front-side quantum-well structure, an energy band of the front-side well layer closest to the main quantum-well structure is lower than or equal to an energy band of the main quantum-well structure.

8. The epitaxial structure for the red-light LED according to claim 1, wherein the active layer further comprises a backside quantum-well structure on the main quantum-well structure, and wherein the backside quantum-well structure is made up of periodic units each consisting of alternately grown backside well layers and backside barrier layers.

9. The epitaxial structure for the red-light LED according to claim 8, wherein the number of periodic units in the backside quantum-well structure ranges from 1 to 10.

10. The epitaxial structure for the red-light LED according to claim 8, wherein each backside well layer is made of a material comprising (Al_{z}Ga_{1-z})_{w}In_{1-w}P, where 0≤z≤0.30 and 0.3≤w≤0.7, and wherein each backside barrier layer is made of a material comprising (AlⱼₖGa₁₋ⱼₖ)_{d}In_{1-d}P, where 0.3≤jk≤1 and 0.3≤d≤0.7.

11. The epitaxial structure for the red-light LED according to claim 8, wherein in the backside quantum-well structure, an Al content of the backside barrier layer in each preceding unit is lower than or equal to an Al content of the backside barrier layer in a succeeding unit.

12. The epitaxial structure for the red-light LED according to claim 8, wherein in the backside quantum-well structure, a thickness of the backside barrier layer in each preceding unit is less than or equal to a thickness of the backside barrier layer in a succeeding unit.

13. The epitaxial structure for the red-light LED according to claim 8, wherein the backside quantum-well structure has a total thickness of 3 nm to 120 nm, wherein each periodic unit of the backside quantum-well structure has a thickness of 3 nm to 12 nm, and wherein the backside well layers and the backside barrier layers in each periodic unit both have a thickness of 1.5 nm to 10.5 nm.

14. The epitaxial structure for the red-light LED according to claim 8, wherein in each periodic unit of the backside quantum-well structure, the backside barrier layer has a uniform or gradually varying Al content, wherein in the case of each backside barrier layer having a gradually varying Al content, the Al content gradually increases in the direction from the first-type semiconductor layer to the second-type semiconductor layer.

15. The epitaxial structure for the red-light LED according to claim 8, wherein the main quantum-well structure is made up of periodic units each consisting of alternately grown main well layers and main barrier layers, wherein the front-side barrier layers have the same material, thickness and composition as the main barrier layers, and the backside well layers have the same material, thickness and composition as the main well layers.

16. The epitaxial structure for the red-light LED according to claim 15, wherein the number of periodic units in the main quantum-well structure ranges from 5 to 35, wherein the main quantum-well structure has a total thickness of 15 nm to 420 nm; each periodic unit of the main quantum-well structure has a thickness of 3 nm to 12 nm; and the main well layers and the main barrier layers in each periodic unit both have a thickness of 1.5 nm to 10.5 nm.

17. The epitaxial structure for the red-light LED according to claim 1, further comprising a bottom buffer layer and an etch stop layer, which are sequentially stacked in the order, the bottom buffer layer located on the substrate, the etch stop layer located between the bottom buffer layer and the first-type semiconductor layer.

18. The epitaxial structure for the red-light LED according to claim 1, wherein the first-type semiconductor layer comprises a first-type ohmic contact layer, a first-type window layer, a first-type confinement layer and a first barrier layer, which are stacked in sequence from the bottom upwards.

19. The epitaxial structure for the red-light LED according to claim 1, wherein the second-type semiconductor layer comprises a second barrier layer, a second-type confinement layer, a second-type current-spreading layer and a second-type ohmic contact layer, which are stacked in sequence from the bottom upwards.

20. A method of preparing an epitaxial structure for a red-light LED, comprising the steps of:
providing a substrate;
sequentially growing a first-type semiconductor layer and an active layer over the substrate, the active layer comprising a front-side quantum-well structure and a main quantum-well structure, which are stacked in sequence from the bottom upwards, the front-side quantum-well structure in the form of a periodic structure made up of periodic units each consisting of alternately grown front-side well layers and the front-side barrier layers, the front-side well layers containing aluminum (Al), an Al content of the front-side well layer in each preceding unit lower than an Al content of the front-side well layer in a succeeding unit; and
growing a second-type semiconductor layer over the active layer.

21. The method of preparing the epitaxial structure for the red-light LED according to claim 20, wherein the number of periodic units in the front-side quantum-well structure ranges from 1 to 10.

22. The method of preparing the epitaxial structure for the red-light LED according to claim 20, wherein
each front-side well layer is made of a material comprising (AlₓᵢGa₁₋ₓᵢ)_{y}In_{1-y}P, where 0≤xi≤0.3 and 0.3≤y≤0.7, wherein each front-side barrier layer is made of a material comprising (AlₘGa₁₋ₘ)ₙIn₁₋ₙP, where 0.3≤m≤0.8 and 0.3≤n≤0.7.

23. The method of preparing the epitaxial structure for the red-light LED according to claim 20, wherein in the front-side quantum-well structure, a thickness of the front-side well layer in each preceding unit is greater than a thickness of the front-side well layer in a succeeding unit.

24. The method of preparing the epitaxial structure for the red-light LED according to claim 20, wherein the front-side quantum-well structure has a total thickness of 3 nm to 120 nm, wherein each periodic unit of the front-side quantum-well structure has a thickness of 3 nm to 12 nm, and the front-side well layers and the front-side barrier layers in each periodic unit both have a thickness of 1.5 nm to 10.5 nm.

25. The method of preparing the epitaxial structure for the red-light LED according to claim 20, wherein in each periodic unit of the front-side quantum-well structure, the front-side well layer has a uniform or gradually varying Al content, wherein in the case of each front-side well layer having a gradually varying Al content, it has an indium (In) content gradually increasing in a direction from the first-type semiconductor layer to the second-type semiconductor layer.

26. The method of preparing the epitaxial structure for the red-light LED according to claim 20, wherein in the front-side quantum-well structure, an energy band of the front-side well layer closest to the main quantum-well structure is lower than or equal to an energy band of the main quantum-well structure.

27. The method of preparing the epitaxial structure for the red-light LED according to claim 20, wherein the active layer further comprises a backside quantum-well structure on the main quantum-well structure, which is made up of periodic units each consisting of alternately grown backside well layers and the backside barrier layers.

28. The method of preparing the epitaxial structure for the red-light LED according to claim 27, wherein the number of periodic units in the backside quantum-well structure ranges from 1 to 10.

29. The method of preparing the epitaxial structure for the red-light LED according to claim 27, wherein each backside well layer is made of a material comprising (Al_{z}Ga_{1-z})_{w}In_{1-w}P, where 0≤z≤0.30 and 0.3≤w≤0.7, wherein each backside barrier layer is made of a material comprising (AlⱼₖGa₁₋ⱼₖ)_{d}In_{1-d}P, where 0.3≤jk≤1 and 0.3≤d≤0.7.

30. The method of preparing the epitaxial structure for the red-light LED according to claim 27, wherein in the backside quantum-well structure, an Al content of the backside barrier layer in each preceding unit is lower than or equal to an Al content of the backside barrier layer in a succeeding unit.

31. The method of preparing the epitaxial structure for the red-light LED according to claim 27, wherein in the backside quantum-well structure, a thickness of the backside barrier layer in each preceding unit is less than or equal to a thickness of the backside barrier layer in a succeeding unit.

32. The method of preparing the epitaxial structure for the red-light LED according to claim 27, wherein the backside quantum-well structure has a total thickness of 3 nm to 120 nm, wherein each periodic unit of the backside quantum-well structure has a thickness of 3 nm to 12 nm, and the backside well layers and the backside barrier layers in each periodic unit both have a thickness of 1.5 nm to 10.5 nm.

33. The method of preparing the epitaxial structure for the red-light LED according to claim 27, wherein in each periodic unit of the backside quantum-well structure, the backside barrier layer has a uniform or gradually varying Al content, wherein in the case of each backside barrier layer having a gradually varying Al content, the Al content gradually increases in the direction from the first-type semiconductor layer to the second-type semiconductor layer.

34. The method of preparing the epitaxial structure for the red-light LED according to claim 27, wherein the main quantum-well structure is made up of periodic units each consisting of alternately grown main well layers and main barrier layers, wherein the front-side barrier layers have the same material, thickness and composition as the main barrier layers, and the backside well layers have the same material, thickness and composition as the main well layers.

35. The method of preparing the epitaxial structure for the red-light LED according to claim 34, wherein the main quantum-well structure has a total thickness of 15 nm to 420 nm, wherein each periodic unit of the main quantum-well structure has a thickness of 3 nm to 12 nm, and the main well layers and the main barrier layers in each periodic unit both have a thickness of 1.5 nm to 10.5 nm.

36. The method of preparing the epitaxial structure for the red-light LED according to claim 20, further comprising: growing a bottom buffer layer and an etch stop layer between the substrate and the first-type semiconductor layer, wherein the bottom buffer layer resides on the substrate, and the etch stop layer is situated between the bottom buffer layer and the first-type semiconductor layer.

37. The method of preparing the epitaxial structure for the red-light LED according to claim 20, wherein the first-type semiconductor layer comprises a first-type ohmic contact layer, a first-type window layer, a first-type confinement layer and a first barrier layer, which are stacked in sequence from the bottom upwards.

38. The method of preparing the epitaxial structure for the red-light LED according to claim 20, wherein the second-type semiconductor layer comprises a second barrier layer, a second-type confinement layer, a second-type current-spreading layer and a second-type ohmic contact layer, which are stacked in sequence from the bottom upwards.
